# EUROPÄISCHE PATENTSCHRIFT

(11) **EP 3 276 767 B1**
(45) Veröffentlichungstag und Bekanntmachung des Hinweises auf die Patenterteilung: **20.02.2019**
(21) Anmeldenummer: 17182740.5
(22) Anmeldetag: 24.07.2017
(51) Int. Cl.: H02H 11/00, H02J 7/00, H03K 17/0812

(54) **TRENNSCHALTERANORDNUNG, INSBESONDERE FÜR EIN BORDSPANNUNGSSYSTEM EINES FAHRZEUGS**
DISCONNECTOR ASSEMBLY, IN PARTICULAR FOR AN ON-BOARD POWER SYSTEM OF A VEHICLE
SYSTÈME DE SECTIONNEUR, EN PARTICULIER POUR UN SYSTÈME DE TENSION DE BORD D'UN VÉHICULE AUTOMOBILE

(30) Priorität: 29.07.2016 DE 102016114002
(43) Veröffentlichungstag der Anmeldung: 31.01.2018
(73) Patentinhaber: Eberspächer Controls Landau GmbH & Co. KG, 76829 Landau (DE)
(72) Erfinder: Wandres, Steffen, 76870 Kandel (DE); Knopf, Christian, 68789 St. Leon-Rot (DE)
(74) Vertreter: Ruttensperger Lachnit Trossin Gomoll

(56) Entgegenhaltungen:
- EP-A1- 1 860 774
- EP-A1- 2 131 497
- EP-A1- 2 360 807
- EP-A2- 0 717 497
- DE-A1-102014 108 783
- US-A1- 2006 126 245
- US-A1- 2015 109 706

## Beschreibung

Die vorliegende Erfindung betrifft eine Trennschalteranordnung, insbesondere für ein Bordspannungssystem eines Fahrzeugs. Aus der nachveröffentlichten deutschen Patentanmeldung DE 10 2016 101 081 ist ein Bordspannungssystem für ein Fahrzeug bekannt, bei welchem zwei Spannungsquellen z.B. vermittels zweier durch die Anmelderin der vorliegenden Anmeldung unter der Handelsbezeichnung Q-Diode (Quasi-Diode) vertriebener Trennschalterelemente abhängig vom Betriebszustand mit mehreren Verbrauchern elektrischer Energie gekoppelt werden können. Zum Schalten der zwischen einem Leiter-Zustand und einem Diode-Zustand umschaltbaren Trennschalterelemente ist eine abhängig vom Betriebszustand eine Ansteuerspannung an die Trennschalterelemente anlegende Ansteuereinheit vorgesehen.
Die EP 2 017 935 A2 offenbart ein Trennschalterelement für das Bordspannungssystem eines Fahrzeugs, welches einen Trennschalterelement-Eingangsanschluss, einen Trennschalterelement-Ausgangsanschluss sowie einen Trennschalterelement-Ansteueranschluss aufweist, an welchen die das Trennschalterelement zwischen einem Leiter-Zustand und einem Diode-Zustand umschaltende Ansteuerspannung anzulegen ist.
Werden derartige Trennschalterelemente in einem Diode-Zustand betrieben, so sind diese in einem Sperr-Zustand, wenn das am Trennschalterelement-Eingangsanschluss anliegende Potenzial höher ist, als das am Trennschalterelement-Ausgangsanschluss anliegende Potenzial. Das an einem Trennschalterelement-Eingangsanschluss anliegende Potenzial kann beispielsweise im Wesentlichen bestimmt sein durch die Versorgungsspannung einer ein Bordspannungssystem mit elektrischer Energie speisenden Batterie. Es können grundsätzlich Betriebszustände auftreten, in welchen aufgrund einer Fehlfunktion oder einer Fehlbedienung im Diode-Zustand eines Trennschalterelements das Potenzial am Trennschalterelement-Ausgangsanschluss über dem Potenzial am Trennschalterelement-Eingangsanschluss liegt. Dadurch gelangt das grundsätzlich in seinem Diode-Zustand betriebene Trennschalterelement in einen leitenden Zustand, in welchem ein Stromfluss vom Trennschalterelement-Ausgangsanschluss zum Trennschalterelement-Eingangsanschluss bei vergleichsweise geringem Spannungsabfall erfolgt. In diesem Zustand können Ströme von bis zu 30A fließen, was aufgrund des vorhandenen Spannungsabfalls zu einer vergleichsweise hohen Verlustleistung und dementsprechend einer vergleichsweise starken Erwärmung und somit einer Schädigung eines derartigen Bauteils führen kann.
Eine Trennschalteranordnung gemäß dem Oberbegriff des Anspruchs 1 ist aus der US 2006/0126245 A1 bekannt. Bei dieser bekannten Trennschalteranordnung ist eine Hilfs-Ansteuereinheit vorgesehen, welche bei Anlegen einer Spannung mit verkehrter Polung eine Hilfs-Ansteuerspannung an den Ansteueranschluss des Trennschalters anlegt, um diesen in einen leitenden Zustand zu schalten. Die an den Ansteueranschluss des Trennschalters im Falle verkehrter Polung angelegte Hilfs-Ansteuerspannung entspricht der in diesem Zustand anliegenden Batteriespannung. Es ist die Aufgabe der vorliegenden Erfindung, eine Trennschalteranordnung, insbesondere für ein Bordspannungssystem eines Fahrzeugs, vorzusehen, welche bei Auftreten von Fehlerzuständen oder Fehlgebrauchszuständen selbsttätig eine eine übermäßige Erwärmung vermeidende Schutzfunktion aktiviert.

Erfindungsgemäß wird diese Aufgabe nach Anspruch 1 gelöst durch eine Trennschalteranordnung, insbesondere für ein Bordspannungssystem eines Fahrzeugs, umfassend:
- wenigstens ein Trennschalterelement mit einem Trennschalterelement-Eingangsanschluss, einem Trennschalterelement-Ausgangsanschluss und einem Trennschalterelement-Ansteueranschluss, wobei bei an dem Trennschalterelement-Ansteueranschluss anliegender Ansteuerspannung das Trennschalterelement in einem Leiter-Zustand ist und bei nicht an dem Trennschalterelement-Ansteueranschluss anliegender Ansteuerspannung das Trennschalterelement in einem Diode-Zustand ist, derart, dass das Trennschalterelement in einem Sperr-Zustand ist, wenn der Trennschalterelement-Eingangsanschluss auf höherem Potenzial ist als der Trennschalterelement-Ausgangsanschluss,
- eine Ansteuereinheit zum Bereitstellen einer an den Trennschalterelement-Ansteueranschluss anzulegenden Ansteuerspannung,
- eine Hilfs-Ansteuereinheit zum Bereitstellen einer an den Trennschalterelement-Ansteueranschluss anzulegenden Hilfs-Ansteuerspannung, wobei die Hilfs-Ansteuereinheit dazu ausgebildet ist, die Hilfs-Ansteuerspannung auf der Grundlage eines Spannungsabfalls zwischen dem Trennschalterelement-Eingangsanschluss und dem Trennschalterelement-Ausgangsanschluss zu erzeugen, wenn das Trennschalterelement in seinem Diode-Zustand ist und der Trennschalterelement-Ausgangsanschluss auf höherem Potenzial ist als der Trennschalterelement-Eingangsanschluss,
- wobei die Hilfs-Ansteuereinheit einen mit dem Trennschalterelement-Eingangsanschluss verbundenen ersten Hilfs-Ansteuereinheit-Eingangsanschluss und einen mit dem Trennschalterelement- Ausgangsanschluss verbundenen zweiten Hilfs-Ansteuereinheit-Eingangsanschluss aufweist, und
- wobei die Hilfs-Ansteuereinheit dazu ausgebildet ist, zum Bereitstellen der Hilfs-Ansteuerspannung die zwischen den beiden Hilfs-Ansteuereinheit-Eingangsanschlüssen vorhandene Potenzialdifferenz zu vervielfachen.

Um in der Hilfs-Ansteuereinheit die zwischen dem Trennschalterelement-Eingangsanschluss und dem Trennschalterelement-Ausgangsanschluss vorhandene Potenzialdifferenz erkennen zu können und dementsprechend erforderlichenfalls die Hilfs-Ansteuerspannung erzeugen und an den Trennschalterelement-Ansteueranschluss anlegen zu können, weist die Hilfs-Ansteuereinheit einen mit dem Trennschalterelement-Eingangsanschluss verbundenen ersten Hilfs-Ansteuereinheit-Eingangsanschluss und einen mit dem Trennschalterelement-Ausgangsanschluss verbundenen zweiten Hilfs-Ansteuereinheit-Eingangsanschluss auf.
Zur Erzeugung einer ausreichend hohen Hilfs-Ansteuerspannung ist die Hilfs-Ansteuereinheit dazu ausgebildet, zum Bereitstellen der Hilfs-Ansteuerspannung die zwischen den beiden Hilfs-Ansteuereinheit-Eingangsanschlüssen vorhandene Potenzialdifferenz bzw. die daran anliegende Spannung zu vervielfachen.
Tritt bei einer erfindungsgemäß aufgebauten Trennschalteranordnung ein Zustand auf, in welchem ein Trennschalterelement in seinem Diode-Zustand ist, aufgrund der vorhandenen Potenzialdifferenz aber nicht in seinem Sperr-Zustand, sondern einem leitenden Zustand bzw. Durchlass-Zustand ist, wird eine Hilfs-Ansteuerspannung bereitgestellt, welche an den Trennschalterelement-Ansteueranschluss angelegt wird und somit das Trennschalterelement in seinen Leiter-Zustand schaltet. Da in diesem Leiter-Zustand der elektrische Widerstand und damit auch der Spannungsabfall im Trennschalterelement deutlich geringer sind, als in einem Zustand, in welchem das Trennschalterelement in seinem Diode-Zustand leitend ist, wird weniger Verlustleistung erzeugt, mit der Folge, dass eine übermäßige Erwärmung und somit eine Beschädigung des Trennschalterelements vermieden werden können.

Bei einer insbesondere zum Leiten starker Ströme vorteilhaften Ausgestaltung kann vorgesehen sein, dass das Trennschalterelement ein Trennschalter-MOSFET-Element umfasst, wobei der Trennschalterelement-Ansteueranschluss dem Gate-Anschluss des Trennschalter-MOSFET-Elements entspricht, der Trennschalterelement-Eingangsanschluss dem Drain-Anschluss des Trennschalter-MOSFET-Elements entspricht und der Trennschalterelement-Ausgangsanschluss dem Source-Anschluss des Trennschalter-MOSFET-Elements entspricht. Beispielsweise kann hier ein n-Kanal-MOSFET eingesetzt werden, der durch Anlegen einer positiven Spannung bzw. eines positiven Potenzials an seinen Gate-Anschluss in seinen Leiter-Zustand gebracht werden kann.

Es ist in diesem Fall darauf hinzuweisen, dass beispielsweise der Gate-Anschluss, der Drain-Anschluss und der Source-Anschluss eines derartigen Bauteils direkt den Ansteueranschluss, den Eingangsanschluss bzw. den Ausgangsanschluss des Trennschalterelements bereitstellen können. Alternativ können, beispielsweise bei Ausgestaltung des Trennschalterelements als sogenannte Q-Diode, der Ansteueranschluss oder/und der Eingangsanschluss oder/und der Ausgangsanschluss mit dem Gate-Anschluss, dem Drain-Anschluss bzw. dem Source-Anschluss eines derartigen Bauteils über andere schaltungstechnisch wirksame Bauteile verbunden sein.

Um die Ansteuerspannung bzw. die Hilfs-Ansteuerspannung bzw. ein jeweils entsprechendes Potenzial zum Anlegen an den Trennschalterelement-Ansteueranschluss bereitstellen zu können, wird vorgeschlagen, dass die Ansteuereinheit einen ersten Ansteuereinheit-Ausgangsanschluss zum Anlegen der Ansteuerspannung an den Trennschalterelement-Ansteueranschluss aufweist, oder/und dass die Hilfs-Ansteuereinheit einen Hilfs-Ansteuereinheit-Ausgangsanschluss zum Anlegen der Hilfs-Ansteuerspannung an den Trennschalterelement-Ansteueranschluss aufweist.

Insbesondere in Fällen, in welchen die durch die Hilfs-Ansteuereinheit bereitzustellende Hilfs-Ansteuerspannung niedriger ist, als die durch die Ansteuereinheit bereitzustellende Ansteuerspannung und insofern bei an anliegender Ansteuerspannung eine Störung oder Beschädigung im Bereich der Hilfs-Ansteuereinheit entstehen könnte, wird vorgeschlagen, dass dem Hilfs-Ansteuereinheit-Ausgangsanschluss ein erstes Entkoppel-Schaltelement zugeordnet ist, wobei das erste Entkoppel-Schaltelement den Hilfs-Ansteuereinheit-Ausgangsanschluss vom Trennschalterelement-Ansteueranschluss trennt, wenn die durch die Ansteuereinheit bereitgestellte Ansteuerspannung am Trennschalterelement-Ansteueranschluss anliegt.

Für eine baulich einfach zu realisierende Ausgestaltung kann dabei vorgesehen sein, dass das erste Entkoppel-Schaltelement ein erstes Entkoppel-MOSFET-Element umfasst, dessen Gate-Anschluss mit dem ersten Ansteuereinheit-Ausgangsanschluss vorzugsweise über eine Diode verbunden ist, dessen Drain-Anschluss mit dem Hilfs-Ansteuereinheit-Ausgangsanschluss verbunden ist und dessen Source-Anschluss mit dem Trennschalterelement-Ansteueranschluss verbunden ist. Beispielsweise kann hier ein p-Kanal-MOSFET eingesetzt werden. Es ist darauf hinzuweisen, dass, sofern im Kontext der vorliegenden Erfindung im Zusammenhang mit einem MOSFET von einem Diode-Zustand gesprochen wird, damit der Zustand angesprochen ist, in welchem der Transistor grundsätzlich nicht leitend geschaltet ist, aufgrund der in diesem aber vorhandenen intrinsischen Diode bei Anlegen einer entsprechenden Potenzialdifferenz als Diode entweder in Sperrrichtung oder in Durchlassrichtung wirkt.

Um durch die Ansteuereinheit die zum Schalten des Trennschalterelements erforderliche Potenzialdifferenz zwischen zwei Anschlüssen des Trennschalterelements anlegen zu können, wird vorgeschlagen, dass die Ansteuereinheit einen mit dem Trennschalterelement-Ausgangsanschluss verbundenen zweiten Ansteuereinheit-Ausgangsanschluss aufweist.

Soll das Trennschalterelement, ausgehend von seinem Leiter-Zustand, in seinen Diode-Zustand gebracht werden, ist es im Allgemeinen erforderlich, eine im Bereich des Trennschalterelement-Ansteueranschlusses aufgebaute Kapazität zu entladen.

Es wird daher vorgeschlagen, dass dem Trennschalterelement-Ansteueranschluss ein Entlade-Schaltelement zugeordnet ist, wobei das Entlade-Schaltelement zwischen dem ersten Ansteuereinheit-Ausgangsanschluss und dem Trennschalterelement-Ansteueranschluss angeordnet ist und die Ansteuereinheit die Ansteuerspannung über das Entlade-Schaltelement an den Trennschalterelement-Ansteueranschluss anlegt, und wobei bei nicht durch die Ansteuereinheit bereitgestellter Ansteuerspannung der Trennschalterelement-Ansteueranschluss sich über das Entlade-Schaltelement entladen kann.

Auch hier wird für eine einfach realisierbare Ausgestaltung vorgeschlagen, dass das Entlade-Schaltelement ein Entlade-MOSFET-Element umfasst, dessen Gate-Anschluss mit dem ersten Ansteuereinheit-Ausgangsanschluss vorzugweise über eine Diode verbunden ist, dessen Source-Anschluss mit dem ersten Ansteuereinheit-Ausgangsanschluss verbunden ist und dessen Drain-Anschluss mit dem Trennschalterelement-Ansteueranschluss verbunden ist, wobei bei durch die Ansteuereinheit bereitgestellter Ansteuerspannung das Entlade-MOSFET-Element in seinem Diode-Zustand ist. Beispielsweise kann hier ein n-Kanal-MOSFET eingesetzt werden, der durch Anlegen einer positiven Spannung bzw. eines positiven Potenzials an seinen Gate-Anschluss in seinen Leiter-Zustand gebracht werden kann.

Um den Trennschalterelement-Ansteueranschluss erst mit derartiger Verzögerung vom ersten Ansteuereinheit-Ausgangsanschluss zu trennen, dass eine Entladung der vorangehend angesprochenen Kapazität möglich ist, wird weiter vorgeschlagen, dass dem Entlade-MOSFET-Element eine Entlade-Spannungsquelle zugeordnet ist, wobei die Entlade-Spannungsquelle dazu ausgebildet ist, das Entlade-MOSFET-Element für eine vorbestimmte Zeitdauer nach dem Beenden des Bereitstellens der Ansteuerspannung durch die Ansteuereinheit in seinem Leiter-Zustand zu halten. Beispielsweise kann die Entlade-Spannungsquelle ein R-C-Glied umfassen.

Gemäß einem weiteren Aspekt der vorliegenden Erfindung wird vorgeschlagen, dass der Hilfs-Ansteuereinheit ein zweites Entkoppel-Schaltelement zugeordnet ist, wobei das zweite Entkoppel-Schaltelement zwischen dem ersten Ansteuereinheit-Ausgangsanschluss und dem Hilfs-Ansteuereinheit-Ausgangsanschluss angeordnet ist, und wobei das zweite Entkoppel-Schaltelement bei nicht durch die Ansteuereinheit bereitgestellter Ansteuerspannung und durch die Hilfs-Ansteuereinheit bereitgestellter Hilfs-Ansteuerspannung den Hilfs-Ansteuereinheit-Ausgangsanschluss vom ersten Ansteuereinheit-Ausgangsanschluss entkoppelt. Auf diese Art und Weise ist sichergestellt, dass dann, wenn die Hilfs-Ansteuereinheit die Hilfs-Ansteuerspannung generiert und an den Trennschalterelement-Ansteueranschluss anlegt, der Hilfs-Ansteuereinheit-Ausgangsanschluss von dem z.B. auf dem Potenzial des Trennschalterelement-Ausgangsanschlusses gehaltenen ersten Ansteuereinheit-Ausgangsanschluss getrennt ist.

Beispielsweise kann vorgesehen sein, dass das zweite Entkoppel-Schaltelement ein zweites Entkoppel-MOSFET-Element umfasst, dessen Gate-Anschluss mit dem ersten Ansteuereinheit-Ausgangsanschluss vorzugsweise über eine Diode verbunden ist, dessen Source-Anschluss mit dem ersten Ansteuereinheit-Ausgangsanschluss verbunden ist und dessen Drain-Anschluss wenigstens bei durch die Hilfs-Ansteuereinheit bereitgestellter Hilfs-Ansteuerspannung mit dem Hilfs-Ansteuereinheit-Ausgangsanschluss verbunden ist.

Eine sehr einfache Ausgestaltung kann durch Funktionenverschmelzung dadurch erreicht werden, dass das Entlade-Schaltelement das zweite Entkoppel-Schaltelement bereitstellt.

Um dann, wenn das Trennschalterelement in seinem Diode-Zustand ist, eine durch äußere Einflüsse hervorgerufene Aufladung am Trennschalterelement-Ansteueranschluss zu vermeiden, wird vorgeschlagen, dass die Hilfs-Ansteuereinheit dazu ausgebildet ist, dann, wenn das Trennschalterelement in seinem Diode-Zustand ist, den Trennschalterelement-Ansteueranschluss mit dem Trennschalterelement-Ausgangsanschluss oder/und einem Grundpotenzial-Anschluss zu verbinden. Dies kann beispielsweise dadurch erreicht werden, dass die Hilfs-Ansteuereinheit dazu ausgebildet ist, dann, wenn das Trennschalterelement in seinem Diode-Zustand ist, den Hilfs-Ansteuereinheit-Ausgangsanschluss mit dem zweiten Hilfs-Ansteuereinheit-Eingangsanschluss zu verbinden.

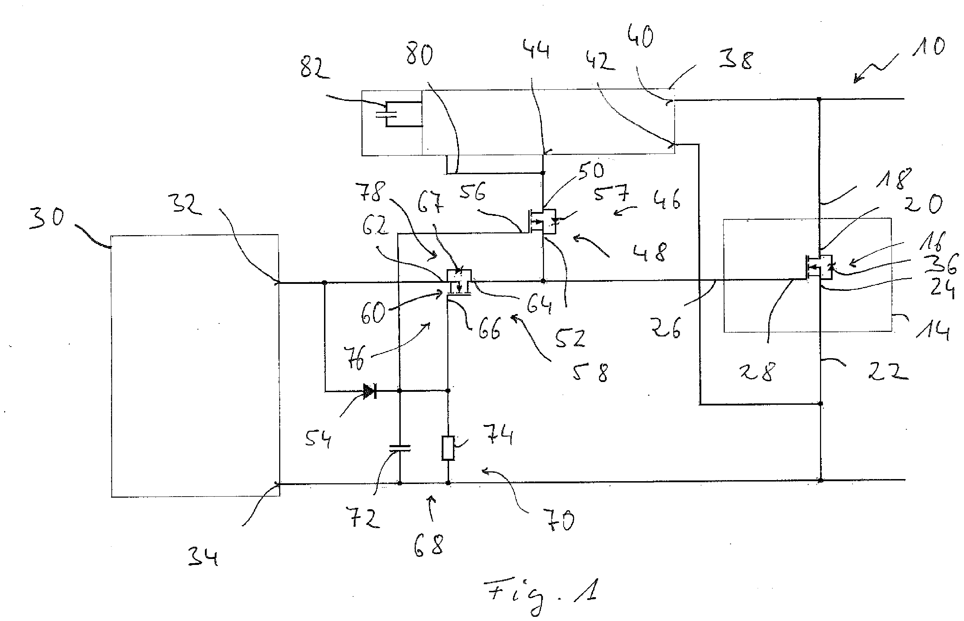

Die vorliegende Erfindung wird nachfolgend mit Bezug auf die Fig. 1 detailliert beschrieben, welche ein Schaltbild einer Trennschalteranordnung z.B. für ein Bordspannungssystem eines Fahrzeugs darstellt.

In Fig. 1 ist eine Trennschalteranordnung, welche beispielsweise in einem Fahrzeug eingesetzt werden kann, um eine Spannungsquelle in das Bordspannungssystem einzukoppeln bzw. mit in einem Fahrzeug vorgesehenen Verbrauchern verbinden zu können, allgemein mit 10 bezeichnet. Die Trennschalteranordnung 10 umfasst im dargestellten Beispiel als Trennschalterelement 14 ein Trennschalter-MOSFET-Element 16, welches als n-Kanal-MOSFET ausgebildet sein kann.

Das Trennschalterelement 14 weist einen allgemein mit 18 bezeichneten Trennschalterelement-Eingangsanschluss auf, der beispielsweise dem Drain-Anschluss 20 des Trennschalter-MOSFET-Elements 16 entsprechen kann. Ferner weist das Trennschalterelement 14 einen Trennschalterelement-Ausgangsanschluss 22 auf, der dem Source-Anschluss 24 des Trennschalter-MOSFET-Elements 16 entsprechen kann. Das Trennschalterelement 14 weist ferner einen Trennschalterelement-Ansteueranschluss 26 auf, der dem Gate-Anschluss 28 des Trennschalter-MOSFET-Elements 16 entsprechen kann.

Bei Integration in ein Fahrzeug kann der Eingangsanschluss 18 bzw. der Drain-Anschluss 20 mit einer Fahrzeugbatterie gekoppelt sein und somit beispielsweise auf einem Potenzial von +12V liegen. Der Ausgangsanschluss 22 bzw. der Source-Anschluss 24 kann mit einem oder mehreren Verbrauchern elektrischer Energie bzw. über diese mit dem Massepotenzial verbunden sein.

Dem Trennschalterelement 12 ist eine allgemein mit 30 bezeichnete Ansteuereinheit zugeordnet. Diese ist dazu ausgebildet, eine Spannung bzw. ein Potenzial an den Trennschalterelement-Ansteueranschluss 26 bzw. den Gate-Anschluss 28 anzulegen bzw. eine entsprechende Spannung zwischen dem Trennschalterelement-Ansteueranschluss 26 und dem Trennschalterelement-Ausgangsanschluss 22 anzulegen. Zu diesem Zwecke weist die Ansteuereinheit 30 einen ersten Ansteuereinheit-Ausgangsanschluss 32 auf, der grundsätzlich mit dem Trennschalterelement-Ansteueranschluss 26 verbunden ist, und weist einen zweiten Ansteuereinheit-Ausgangsanschluss 34 auf, der mit dem Trennschalterelement-Ausgangsanschluss 22 verbunden ist. Die durch die Ansteuereinheit 30 an den Trennschalterelement-Ausgangsanschluss 26 angelegte Spannung liegt beispielsweise im Bereich von 6 bis 8V über der Schaltspannung bzw. Schwellenspannung des Trennschalter-MOSFET-Elements 16, so dass durch Anlegen dieser Ansteuerspannung an den Trennschalterelement-Ausgangsanschluss 26 das Trennschalterelement 14 in seinen Leiter-Zustand gebracht wird, in welchem das Trennschalterelement 14 grundsätzlich leitend ist, der Trennschalterelement-Eingangsanschluss 18 also niederohmig mit dem Trennschalterelement-Ausgangsanschluss 22 verbunden ist. Liegt diese Ansteuerspannung am Trennschalterelement-Ansteueranschluss 26 nicht an, ist das Trennschalterelement 14 in einem Diode-Zustand. Bei Ausgestaltung des Trennschalterelements 14 mit einem Trennschalter-MOSFET-Element 16 wird dieser Diode-Zustand grundsätzlich aufgrund der bei einem derartigen Bauteil vorhandenen und mit dem Bezugszeichen 36 angedeuteten intrinsischen Diode bereitgestellt. Diese ist zwischen dem Trennschalterelement-Eingangsanschluss 18 und dem Trennschalterelement-Ausgangsanschluss 22 in Sperrrichtung geschaltet, so dass dann, wenn das Potenzial am Trennschalterelement-Eingangsanschluss 28 (hier ist allgemein die Rede von einem positiven Potenzial) über dem Potenzial am Trennschalterelement-Ausgangsanschluss 22 ist, das grundsätzlich im Diode-Zustand gehaltene Trennschalterelement 14 in einem Sperr-Zustand ist, während dann, wenn das Potenzial am Trennschalterelement-Ausgangsanschluss 22 über dem Potenzial am Trennschalterelement-Eingangsanschluss 18 ist, das Trennschalter-MOSFET-Element 16 in einem leitenden Zustand bzw. einem Durchlass-Zustand ist, in welchem über die intrinsische Diode 36 ein Spannungsabfall im Bereich von 0,6V auftritt.

Es sei hier darauf hingewiesen, dass auch mehrere derartige Trennschalterelemente 14, beispielsweise aufgebaut jeweils mit einem oder mehreren Trennschalter-MOSFET-Elements 16, vorgesehen sein können, beispielsweise in Parallelschaltung. Auch könnte ein derartiges Trennschalterelement 14 als so genannte Q-Diode aufgebaut sein. Auch eine derartige Q-Diode kann grundsätzlich zwischen einem Leiter-Zustand und einem Diode-Zustand umgeschaltet werden und weist z.B. einen einem Drain-Anschluss entsprechenden Eingangs-Anschluss, einen einem Source-Anschluss entsprechenden Ausgangs-Anschluss sowie einen einem Gate-Anschluss entsprechenden an Steueranschluss, ggf. auch einen Masse-Anschluss auf.

Die Trennschalteranordnung 10 umfasst ferner eine allgemein mit dem Bezugszeichen 38 bezeichnete Hilfs-Ansteuereinheit. Die Hilfs-Ansteuereinheit 38 weist einen ersten Hilfs-Ansteuereinheit-Eingangsanschluss 40 auf, der mit dem Trennschalterelement-Eingangsanschluss 18 verbunden ist, und weist einen zweiten Hilfs-Ansteuereinheit-Eingangsanschluss 42 auf, der mit dem Trennschalterelement-Ausgangsanschluss 22 verbunden ist. Außer dieser Ankopplung an die beiden Anschlüsse 18, 22 des Trennschalterelements 14 ist die Hilfs-Ansteuereinheit 38 vorzugsweise nicht mit irgendeiner weiteren Spannungsquelle gekoppelt. Die Hilfs-Ansteuereinheit 38 weist ferner einen Hilfs-Ansteuereinheit-Ausgangsanschluss 44 auf, über welchen die Hilfs-Ansteuereinheit 38 eine Hilfs-Ansteuerspannung an den Trennschalterelement-Ansteueranschluss 26 anlegen kann bzw. eine entsprechende Spannung zwischen den Trennschalterelement-Ausgangsanschluss 22 und dem Trennschalterelement-Ansteueranschluss 26 anlegen kann.

Der Hilfs-Ansteuereinheit 38 ist ein allgemein mit 46 bezeichnetes erstes Entkoppel-Schaltelement zugeordnet. Dieses kann beispielsweise ein erstes Entkoppel-MOSFET-Element 48 umfassen, das, beispielsweise ausgebildet als p-Kanal-MOSFET, einen mit dem Hilfs-Ansteuereinheit-Ausgangsanschluss 44 verbundenen Drain-Anschluss 50, einen mit dem Trennschalterelement-Ansteueranschluss 26 verbundenen Source-Anschluss 52 sowie einen über eine Diode 54 mit dem ersten Ansteuereinheit-Ausgangsanschluss 32 verbundenen Gate-Anschluss 56 aufweist. Das erste Entkoppel-Schaltelement 46 ist somit grundsätzlich in einem Sperr-Zustand bzw. Diode-Zustand, in welchem der Hilfs-Ansteuereinheit-Ausgangsanschluss 44 vom Trennschalterelement-Ansteueranschluss 26 entkoppelt ist, wenn über die Diode 54 die durch die Ansteuereinheit 30 am ersten Ansteuereinheit-Ausgangsanschluss 32 bereitgestellte Ansteuerspannung am Trennschalterelement-Ansteueranschluss 26 und auch am Gate-Anschluss 56 sowie am Source-Anschluss 52 des Entkoppel-MOSFET-Elements 48 anliegt. Auf diese Art und Weise wird insbesondere in Phasen, in welchen das Trennschalterelement 14 in seinen Leiter-Zustand geschaltet ist, der Hilfs-Ansteuereinheit-Ausgangsanschluss 44 vor der am ersten Ansteuereinheit-Ausgangsanschluss 32 bereitgestellten Ansteuerspannung geschützt.

Dem Trennschalterelement 14 bzw. dem Trennschalterelement-Ansteueranschluss 26 ist ferner ein allgemein mit 58 bezeichnetes Entlade-Schaltelement zugeordnet. Dieses kann beispielsweise mit einem Entlade-MOSFET-Element 60 aufgebaut sein, das mit seinem Source-Anschluss 62 mit dem ersten Ansteuereinheit-Ausgangsanschluss 32 verbunden ist, mit seinem Drain-Anschluss 64 mit dem Trennschalterelement-Ansteueranschluss 26 verbunden ist und mit seinem Gate-Anschluss 66 über die Diode 54 mit dem ersten Ansteuereinheit-Ausgangsanschluss 32 verbunden ist. Wird durch die Ansteuereinheit 30 die Ansteuerspannung generiert bzw. am ersten Ansteuereinheit-Ausgangsanschluss 32 ein entsprechendes Potenzial bereitgestellt, so wird dieses über die Diode 54 an den Gate-Anschluss 66 des Entlade-MOSFET-Elements 60 angelegt, welches beispielsweise als n-Kanal-MOSFET ausgebildet ist. Die Ansteuerspannung liegt auch am Source-Anschluss 62 an, so dass aufgrund fehlender Potenzialdifferenz zwischen dem Gate-Anschluss 66 und dem Source-Anschluss 62 das Entlade-MOSFET-Element 60 in seinem Diode-Zustand verbleibt. Die Ansteuerspannung liegt in diesem Zustand über die intrinsische Diode 67 des Entlade-MOSFET-Elements 60 am Trennschalterelement-Ansteueranschluss 26 an, so dass das Trennschalterelement 14 in seinen Leiter-Zustand geschaltet wird.

Dem Entlade-Schaltelement 58 ist ferner eine allgemein mit 68 bezeichnete Entlade-Spannungsquelle zugeordnet. Diese umfasst ein R-C-Glied 70 mit einem Kondensator 72 und einem dazu parallel geschalteten Widerstand 74. Das R-C-Glied 70 ist zwischen dem Gate-Anschluss 66 des Entlade-MOSFET-Elements 60 und dem zweiten Ansteuereinheit-Ausgangsanschluss 34 bzw. dem Trennschalterelement-Ausgangsanschluss 22 geschaltet, welcher beispielsweise über die bereits angesprochenen Verbraucher mit dem Grundpotenzial bzw. dem Massepotenzial verbunden sein kann.

Bei anliegender Ansteuerspannung wird der Kondensator 72 des R-C-Glieds 70 geladen. Wird das Anlegen der Ansteuerspannung beendet, so würde dies grundsätzlich bedeuten, dass das Entlade-Schaltelement 58 in seinem Diode-Zustand ein Entladen der Gate-Kapazität des Trennschalterelement-Ansteueranschlusses 26 bzw. des Gate-Anschlusses 28 verhindert. Da zunächst aber durch die Entlade-Spannungsquelle 68 eine am Gate-Anschluss 66 anliegende Spannung geliefert wird, wird das Entlade-MOSFET-Element 60 in seinen Leiter-Zustand geschaltet, so dass der Gate-Anschluss 28 sich über das Entlade-Schaltelement 58 und den ersten Ansteuereinheit-Ausgangsanschluss 32 entladen kann. Die Entlade-Spannungsquelle 68 ist so ausgelegt, dass die durch diese bereitgestellte Spannung so lange aufrecht erhalten bleibt bzw. nicht unter die Schaltspannung bzw. Schwellenspannung des Entlade-MOSFET-Elements 60 fällt, bis die Gate-Kapazität des Gate-Anschlusses 28 im Wesentlichen vollständig über den ersten Ansteuereinheit-Ausgangsanschluss 32 entladen ist.

Das Entlade-Schaltelement 58 stellt gleichzeitig auch ein zweites Entkoppel-Schaltelement 76 bereit, so dass das Entlade-MOSFET-Element 60 gleichermaßen als zweites Entkoppel-MOSFET-Element 78 wirksam ist. Dieses zweite Entkoppel-Schaltelement 76 ist dann, wenn durch die Ansteuereinheit 30 keine Ansteuerspannung generiert wird, grundsätzlich in seinem Diode-Zustand, in welchem es den Trennschalterelement-Ansteueranschluss 26 vom ersten Ansteuereinheit-Ausgangsanschluss 32 entkoppelt. Da der Hilfs-Ansteuereinheit-Ausgangsanschluss 44 über das erste Entkoppel-Schaltelement 46 mit dem Trennschalterelement-Ansteueranschluss 26 verbunden bzw. verbindbar ist, ist in einem Zustand, in welchem das erste Entkoppel-Schaltelement 46 in seinem Leiter-Zustand ist und das zweite Entkoppel-Schaltelement 76 in seinem Diode-Zustand ist, der Source-Anschluss 52 des ersten Entkoppel-MOSFET-Elements 48 und damit auch der Hilfs-Ansteuereinheit-Ausgangsanschluss 44 vom ersten Ansteuereinheit-Ausgangsanschluss 32 entkoppelt. Dies gewährleistet, dass dann, wenn, wie nachfolgend beschrieben, die Hilfs-Ansteuereinheit 38 eine Hilfs-Ansteuerspannung generiert, der Hilfs-Ansteuereinheit-Ausgangsanschluss 44 auf entsprechend hohem Potenzial bleiben kann bzw. dieses an den Trennschalterelement-Ansteueranschluss 26 anlegen kann.

Soll durch die Trennschalteranordnung 10 die mit dem Trennschalterelement-Eingangsanschluss 18 verbundene Spannungsquelle bzw. deren hohes Potenzial an einen mit dem Trennschalterelement-Ausgangsanschluss 22 gekoppelten Verbraucher angelegt werden, so wird in der vorangehend beschriebenen Art und Weise durch die Ansteuereinheit 30 die Ansteuerspannung generiert und ein entsprechendes Potenzial an den Trennschalterelement-Ansteueranschluss 26 angelegt. Durch die dann zwischen dem Trennschalterelement-Ansteueranschluss 26 und dem Trennschalterelement-Ausgangsanschluss 22 vorhandene Spannung bzw. Potenzialdifferenz wird das Trennschalterelement 14 in seinen Leiter-Zustand geschaltet. Die Hilfs-Ansteuereinheit 38 ist durch das erste Entkoppel-Schaltelement 48 in diesem Zustand vom Trennschalterelement-Ansteueranschluss 26 und ebenso vom ersten Ansteuereinheit-Ausgangsanschluss 32 entkoppelt.

Soll die Verbindung zwischen der Spannungsquelle und dem bzw. den Verbrauchern unterbrochen werden, wird das Anlegen der Ansteuerspannung beendet. Der Trennschalterelement-Ansteueranschluss 26 kann sich über das Entlade-Schaltelement 58 entladen, so dass das Trennschalterelement 14 in seinen Diode-Zustand übergeht, in welchem es bei grundsätzlich korrekter Funktion in seinem Sperr-Zustand ist, also das höhere Potenzial am Trennschalterelement-Eingangsanschluss 18 von dem niedrigeren Potenzial am Trennschalterelement-Ausgangsanschluss 24 entkoppelt.

Es können in einem Fahrzeug Fehlerzustände bzw. Fehlbedienungszustände auftreten, in welchen das am Trennschalterelement-Ausgangsanschluss 22 anliegende Potenzial das am Trennschalterelement-Eingangsanschluss 18 anliegende Potenzial, also die von der Spannungsquelle gelieferte Spannung, übersteigt. Dies kann beispielsweise dann der Fall sein, wenn aufgrund fehlerhafter Bedienung ein Batterieladegerät an den Trennschalterelement-Ausgangsanschluss 22 angeschlossen wird, welches eine größere Spannung liefert, als die mit dem Trennschalterelement-Eingangsanschluss 18 verbundene Batterie bzw. Spannungsquelle. In diesem Falle liegt das Potenzial am Trennschalterelement-Ausgangsanschluss 22 über dem Potenzial am Trennschalterelement-Eingangsanschluss 18, so dass das grundsätzlich in seinem Diode-Zustand gehaltene Trennschalterelement 14 in Durchlassrichtung betrieben wird und somit ein Stromfluss vom Trennschalterelement-Ausgangsanschluss 22 zum Trennschalterelement-Eingangsanschluss 18 und weiter in Richtung zur Spannungsquelle erfolgt. Aufgrund des im Trennschalter-MOSFET-Element 16 dabei auftretenden Spannungsabfalls von etwa 0,6 V und der dabei auch möglichen Ströme im Bereich von bis zu 30A entsteht eine vergleichsweise große Verlustleistung, die zu einer substantiellen Erwärmung des Trennschalterelements 14 und ggf. einer Beschädigung desselben führen kann. Würde in einem derartigen Zustand gleichzeitig auch ein Defekt im Bereich der Ansteuereinheit 30 auftreten, beispielsweise ein Masseverlust oder eine Abkopplung derselben von der Spannungsversorgung, so wäre auch die Ansteuereinheit 30 nicht dazu in der Lage, die Ansteuerspannung zu generieren und dadurch das Trennschalterelement 14 in sein leitenden Zustand zu bringen, um dadurch die Verlustleistung im Trennschalterelement 14 und somit dessen Erwärmung substantiell zu verringern.

Um diesem Problem entgegenzutreten, ist die Hilfs-Ansteuereinheit 38 derart konfiguriert, dass sie aufgrund ihrer Verbindung mit dem Trennschalterelement-Eingangsanschluss 18 und dem Trennschalterelement-Ausgangsanschluss 22 das Auftreten einer derartigen Potenzialdifferenz bzw. umgekehrten Spannung im Trennschalterelement 14 erkennt und dann, wenn ein derartiger Spannungsabfall im Trennschalterelement 14 mit in Durchlassrichtung beaufschlagter intrinsischer Diode 36 auftritt, am Hilfs-Ansteuereinheit-Ausgangsanschluss 44 eine Hilfs-Ansteuerspannung bereitstellt. Dabei kann die Hilfs-Ansteuereinheit 38 dazu ausgebildet sein, die zwischen den beiden Hilfs-Ansteuereinheit-Eingangsanschlüssen 40, 42 anliegende Spannung zu vervielfachen, so dass beispielsweise die am Trennschalterelement 14 im Durchlassbetrieb der intrinsischen Diode 36 auftretende und durch die Hilfs-Ansteuereinheit 38 abgegriffene Spannung von beispielsweise 0,6V in eine Spannung im Bereich von 6V umgewandelt und als entsprechende Hilfs-Ansteuerspannung über das in diesem Zustand in seinem Leiter-Zustand gehaltene erste Entkoppel-Schaltelement 46 an den Trennschalterelement-Ansteueranschluss 26 angelegt wird. Das Trennschalterelement 14 wird dadurch in seinen Leiter-Zustand geschaltet, so dass nur ein vernachlässigbarer Spannungsabfall im Trennschalterelement 14 auftritt und eine fortgesetzte Erwärmung des Trennschalterelements 14 vermieden wird.

Die durch die Hilfs-Ansteuereinheit 38 bereitgestellte Hilfs-Ansteuerspannung liegt über die in diesem Zustand in Durchlassrichtung wirksame intrinsische Diode 57 des ersten Entkoppel-MOSFET-Elements 48 und dessen Source-Anschluss 52 am Trennschalterelement-Ansteueranschluss 26 an. Aufgrund der dabei zwischen dem Source-Anschluss 52 und dem Gate- Anschluss 56 entstehenden Potenzialdifferenz wird das erste Entlade-MOSFET-Element 48 in seinen Leiter-Zustand geschaltet und somit die Hilfs-Ansteuerspannung über das niederohmige erste Entlade-MOSFET-Element 48 an den Gate-Anschluss 28 des 14 angelegt.

Um bei Anlegen der Hilfs-Ansteuerspannung an den Trennschalterelement-Ansteueranschluss 26 und dem dadurch auch induzierten Absinken der Spannung bzw. Potenzialdifferenz zwischen den beiden Hilfs-Ansteuereinheit-Eingangsanschlüssen 40, 42 zu verhindern, dass das Trennschalterelement 14 aufgrund nicht mehr vorhandener Potenzialdifferenz zwischen dem Trennschalterelement-Eingangsanschluss 18 und dem Trennschalterelement-Ausgangsanschluss 22 sofort wieder in seinen Diode-Zustand gelangt, kann die Hilfs-Ansteuereinheit 38 beispielsweise so aufgebaut sein, dass die Hilfs-Ansteuerspannung über einen Kondensator 82 oder eine entsprechende Baugruppe generiert bzw. an den Trennschalterelement-Ansteueranschluss 26 angelegt wird. Dabei kann die Zeitkonstante so sein, dass das Verhältnis von Aufladezeit zu Entladezeit im Bereich von 2/98 liegt, d.h. etwa 2 % der Zeit erforderlich sind, um diesen Kondensator 82 zu laden und somit die Hilfs-Ansteuerspannung bereitstellen zu können, während dann über 98 % der Zeit durch die Hilfs-Ansteuerspannung das Trennschalterelement 14 in seinem Leiter-Zustand gehalten werden kann. Die Zeitdauer für einen derartigen Zyklus kann durch Auswahl des Kondensators 82 festgelegt werden. Es findet also ein ständiges Umschalten zwischen Leiter-Zustand und Diode-Zustand statt, wobei aufgrund des Umstandes, dass nur während des deutlich geringeren Zeitanteils das Trennschalterelement 14 in seinem Diode-Zustand ist, die Zeitphasen, in welchen die an sich zu vermeidende Erwärmung auftreten kann, vergleichsweise kurz ist.

Die Hilfs-Ansteuereinheit 38 stellt neben der vorangehend beschriebenen Funktionalität zum Bereitstellen einer Hilfs-Ansteuerspannung aus dem im Bereich des Trennschalterelements 14 selbst auftretenden Spannungsabfall auch eine Funktionalität zum Entladen des Trennschaltelement-Ansteueranschlusses 26 bzw. Gate-Anschlusses 28 des Trennschalter-MOSFET-Elements 16 bereit, wenn das Trennschalterelement 14 in seinem Diode-Zustand ist. In diesem Zustand ist durch das Entlade-Schaltelement 58 der Trennschalterelement-Ansteueranschluss 26, also der Gate-Anschluss 28, grundsätzlich von der Ansteuereinheit 30 entkoppelt. Z.B. durch ungünstige äußere Einflüsse besteht die Möglichkeit, dass der Trennschalterelement-Eingangsanschluss 26 sich auflädt. Um dies zu vermeiden, weist die Hilfs-Ansteuereinheit 38 eine Entladefunktionalität auf, bei welcher dann, wenn keine Hilfs-Ansteuerspannung generiert wird, über eine in der Fig. 1 angedeutete Verbindung 80 der Source-Anschluss 50 des ersten Entkoppel-Schaltelements 46 mit dem zweiten Hilfs-Ansteuereinheit-Eingangsanschluss 42 und über diesen mit dem Trennschalterelement-Ausgangsanschluss 22 verbunden wird. Somit kann der Trennschalterelement-Ansteueranschluss 26 sich über diese Verbindung entladen. Diese Entlade-Funktionalität kann sowohl dann genutzt werden, wenn im Diode-Zustand des Trennschalterelements 14 dessen intrinsische Diode 36 in Sperrrichtung wirksam ist, also das Potenzial am Drain-Anschluss 20 über dem Potenzial am Source-Anschluss 22 liegt, als auch dann, wenn im Falle der Spannungsumkehr die intrinsische Diode 36 leitend ist, die Hilfs-Ansteuereinheit 38 während einer Aufladephase des Kondensators 82 jedoch keine Hilfs-Ansteuerspannung generiert. In diesem Zustand wird durch das verbesserte Entladen der Gate-Kapazität des Gate-Anschlusses 28 ein verbessertes Schaltverhalten des Trennschalterelements 14 bei Anlegen der Hilfs-Ansteuerspannung erreicht.

Es ist abschließend darauf hinzuweisen, dass die vorangehend beschriebene Funktionalität der Hilfs-Ansteuereinheit 38 beispielsweise bereitgestellt werden kann durch ein von der Firma Texas Instruments (Marke) unter der Handelsbezeichnung "LM74610-Q1 ZERO IQ REVERSE POLARITY PROTECTION SMART DIODE CONTROLLER" vertriebenes Bauteil. Dieses kann bei der vorangehend mit Bezug auf die Fig. 1 beschriebenen Integration in eine Trennschalteranordnung sowohl die Funktionalität zum Erzeugen der Hilfs-Ansteuerspannung, als auch die Funktionalität zum Entladen des Trennschalterelement-Ansteueranschlusses bereitstellen.

## Patentansprüche

1. Trennschalteranordnung, insbesondere für ein Bordspannungssystem eines Fahrzeugs, umfassend:
- wenigstens ein Trennschalterelement (14) mit einem Trennschalterelement-Eingangsanschluss (18), einem Trennschalterelement-Ausgangsanschluss (22) und einem Trennschalterelement-Ansteueranschluss (26), wobei bei an dem Trennschalterelement-Ansteueranschluss (26) anliegender Ansteuerspannung das Trennschalterelement (14) in einem Leiter-Zustand ist und bei nicht an dem Trennschalterelement-Ansteueranschluss (26) anliegender Ansteuerspannung das Trennschalterelement (14) in einem Diode-Zustand ist, derart, dass das Trennschalterelement (14) in einem Sperr-Zustand ist, wenn der Trennschalterelement-Eingangsanschluss (18) auf höherem Potenzial ist als der Trennschalterelement-Ausgangsanschluss (22),
- eine Ansteuereinheit (30) zum Bereitstellen einer an den Trennschalterelement-Ansteueranschluss (26) anzulegenden Ansteuerspannung,
- eine Hilfs-Ansteuereinheit (38) zum Bereitstellen einer an den Trennschalterelement-Ansteueranschluss (26) anzulegenden Hilfs-Ansteuerspannung, wobei die Hilfs-Ansteuereinheit (38) dazu ausgebildet ist, die Hilfs-Ansteuerspannung auf der Grundlage eines Spannungsabfalls zwischen dem Trennschalterelement-Eingangsanschluss (18) und dem Trennschalterelement-Ausgangsanschluss (22) zu erzeugen, wenn das Trennschalterelement (14) in seinem Diode-Zustand ist und der Trennschalterelement-Ausgangsanschluss (22) auf höherem Potenzial ist als der Trennschalterelement-Eingangsanschluss (14), wobei die Hilfs-Ansteuereinheit (38) einen mit dem Trennschalterelement-Eingangsanschluss (18) verbundenen ersten Hilfs-Ansteuereinheit-Eingangsanschluss (40) und einen mit dem Trennschalterelement-Ausgangsanschluss (22) verbundenen zweiten Hilfs-Ansteuereinheit-Eingangsanschluss (42) aufweist,
**dadurch gekennzeichnet, dass** die Hilfs-Ansteuereinheit (38) dazu ausgebildet ist, zum Bereitstellen der Hilfs-Ansteuerspannung die zwischen den beiden Hilfs-Ansteuereinheit-Eingangsanschlüssen (40, 42) vorhandene Potenzialdifferenz zu vervielfachen.

2. Trennschalteranordnung nach Anspruch 1, **dadurch gekennzeichnet, dass** das Trennschalterelement (14) ein Trennschalter-MOSFET-Element (16) umfasst, wobei der Trennschalterelement-Ansteueranschluss (26) dem Gate-Anschluss (28) des Trennschalter-MOSFET-Elements (16) entspricht, der Trennschalterelement-Eingangsanschluss (18) dem Drain-Anschluss (20) des Trennschalter-MOSFET-Elements (16) entspricht und der Trennschalterelement-Ausgangsanschluss (22) dem Source-Anschluss (24) des Trennschalter-MOSFET-Elements (16) entspricht.

3. Trennschalteranordnung nach Anspruch 1 oder 2, **dadurch gekennzeichnet, dass** die Ansteuereinheit (30) einen ersten Ansteuereinheit-Ausgangsanschluss (32) zum Anlegen der Ansteuerspannung an den Trennschalterelement-Ansteueranschluss (26) aufweist, oder/und dass die Hilfs-Ansteuereinheit (38) einen Hilfs-Ansteuereinheit-Ausgangsanschluss (44) zum Anlegen der Hilfs-Ansteuerspannung an den Trennschalterelement-Ansteueranschluss (26) aufweist.

4. Trennschalteranordnung nach Anspruch 3, **dadurch gekennzeichnet, dass** dem Hilfs-Ansteuereinheit-Ausgangsanschluss (44) ein erstes Entkoppel-Schaltelement (46) zugeordnet ist, wobei das erste Entkoppel-Schaltelement (46) den Hilfs-Ansteuereinheit-Ausgangsanschluss (44) vom Trennschalterelement-Ansteueranschluss (26) trennt, wenn die durch die Ansteuereinheit (30) bereitgestellte Ansteuerspannung am Trennschalterelement-Ansteueranschluss (26) anliegt.

5. Trennschalteranordnung nach Anspruch 4 **dadurch gekennzeichnet, dass** das erste Entkoppel-Schaltelement (46) ein erstes Entkoppel-MOSFET-Element (48) umfasst, dessen Gate-Anschluss (56) mit dem ersten Ansteuereinheit-Ausgangsanschluss (32) vorzugsweise über eine Diode (54) verbunden ist, dessen Drain-Anschluss (50) mit dem Hilfs-Ansteuereinheit-Ausgangsanschluss (44) verbunden ist und dessen Source-Anschluss (52) mit dem Trennschalterelement-Ansteueranschluss (26) verbunden ist.

6. Trennschalteranordnung nach einem der vorangehenden Ansprüche, **dadurch gekennzeichnet, dass** die Ansteuereinheit (30) einen mit dem Trennschalterelement-Ausgangsanschluss (22) verbundenen zweiten Ansteuereinheit-Ausgangsanschluss (34) aufweist.

7. Trennschalteranordnung nach Anspruch 3 oder einem der Ansprüche 4-6, sofern auf Anspruch 3 rückbezogen, **dadurch gekennzeichnet, dass** dem Trennschalterelement-Ansteueranschluss (26) ein Entlade-Schaltelement (58) zugeordnet ist, wobei das Entlade-Schaltelement (58) zwischen dem ersten Ansteuereinheit-Ausgangsanschluss (32) und dem Trennschalterelement-Ansteueranschluss (26) angeordnet ist und die Ansteuereinheit (30) die Ansteuerspannung über das Entlade-Schaltelement (58) an den Trennschalterelement-Ansteueranschluss (26) anlegt, und wobei bei nicht durch die Ansteuereinheit (30) bereitgestellter Ansteuerspannung der Trennschalterelement-Ansteueranschluss (26) sich über das Entlade-Schaltelement (58) entladen kann.

8. Trennschalteranordnung noch Anspruch 7, **dadurch gekennzeichnet, dass** das Entlade-Schaltelement (58) ein Entlade-MOSFET-Element (60) umfasst, dessen Gate-Anschluss (66) mit dem ersten Ansteuereinheit-Ausgangsanschluss (32) vorzugweise über eine Diode (54) verbunden ist, dessen Source-Anschluss (62) mit dem ersten Ansteuereinheit-Ausgangsanschluss (32) verbunden ist und dessen Drain-Anschluss (64) mit dem Trennschalterelement-Ansteueranschluss (26) verbunden ist, wobei bei durch die Ansteuereinheit (30) bereitgestellter Ansteuerspannung das Entlade-MOSFET-Element (60) in seinem Diode-Zustand ist.

9. Trennschalteranordnung nach Anspruch 8, **dadurch gekennzeichnet, dass** dem Entlade-MOSFET-Element (60) eine Entlade-Spannungsquelle (68) zugeordnet ist, wobei die Entlade-Spannungsquelle (60) dazu ausgebildet ist, das Entlade-MOSFET-Element (60) für eine vorbestimmte Zeitdauer nach dem Beenden des Bereitstellens der Ansteuerspannung durch die Ansteuereinheit (30) in seinem Leiter-Zustand zu halten.

10. Trennschalteranordnung nach Anspruch 9, **dadurch gekennzeichnet, dass** die Entlade-Spannungsquelle (68) ein R-C-Glied (70) umfasst.

11. Trennschalteranordnung nach Anspruch 3 oder einem der Ansprüche 4-10, sofern auf Anspruch 3 rückbezogen, **dadurch gekennzeichnet, dass** der Hilfs-Ansteuereinheit (38) ein zweites Entkoppel-Schaltelement (76) zugeordnet ist, wobei das zweite Entkoppel-Schaltelement (76) zwischen dem ersten Ansteuereinheit-Ausgangsanschluss (32) und dem Hilfs-Ansteuereinheit-Ausgangsanschluss (44) angeordnet ist, und wobei das zweite Entkoppel-Schaltelement (76) bei nicht durch die Ansteuereinheit (30) bereitgestellter Ansteuerspannung und durch die Hilfs-Ansteuereinheit (38) bereitgestellter Hilfs-Ansteuerspannung den Hilfs-Ansteuereinheit-Ausgangsanschluss (44) vom ersten Ansteuereinheit-Ausgangsanschluss (32) entkoppelt.

12. Trennschalteranordnung noch Anspruch 11, **dadurch gekennzeichnet, dass** das zweite Entkoppel-Schaltelement (76) ein zweites Entkoppel-MOSFET-Element (78) umfasst, dessen Gate-Anschluss (66) mit dem ersten Ansteuereinheit-Ausgangsanschluss (32) vorzugsweise über eine Diode (54) verbunden ist, dessen Source-Anschluss (62) mit dem ersten Ansteuereinheit-Ausgangsanschluss (32) verbunden ist und dessen Drain-Anschluss (62) wenigstens bei durch die Hilfs-Ansteuereinheit (38) bereitgestellter Hilfs-Ansteuerspannung mit dem Hilfs-Ansteuereinheit-Ausgangsanschluss (44) verbunden ist.

13. Trennschalteranordnung nach Anspruch 7 und Anspruch 11 oder 12, **dadurch gekennzeichnet, dass** das Entlade-Schaltelement (58) das zweite Entkoppel-Schaltelement (76) bereitstellt.

14. Trennschalteranordnung nach einem der vorangehenden Ansprüche, **dadurch gekennzeichnet, dass** die Hilfs-Ansteuereinheit (38) dazu ausgebildet ist, dann, wenn das Trennschalterelement (14) in seinem Diode-Zustand ist, den Trennschalterelement-Ansteueranschluss (26) mit dem Trennschalterelement-Ausgangsanschluss (22) oder/und einem Grundpotenzial-Anschluss zu verbinden.

15. Trennschalteranordnung nach Anspruch 14, **dadurch gekennzeichnet, dass** die Hilfs-Ansteuereinheit (36) dazu ausgebildet ist, dann, wenn das Trennschalterelement (14) in seinem Diode-Zustand ist, den Hilfs-Ansteuereinheit-Ausgangsanschluss (44) mit dem zweiten Hilfs-Ansteuereinheit-Eingangsanschluss (42) zu verbinden.

## Claims

1. Circuit breaker device, especially for a vehicle electrical system, comprising:
- at least one circuit breaker component (14) with a circuit breaker component input terminal (18), with a circuit breaker component output terminal (22) and with a circuit breaker component driving terminal (26), wherein the circuit breaker component (14) is in a conductor state when driving voltage is applied to the circuit breaker component driving terminal (26) and the circuit breaker component (14) is in a diode state when driving voltage is not applied to the circuit breaker component driving terminal (26) such that the circuit breaker component (14) is in a blocked state when the circuit breaker component input terminal (18) is at a higher potential than the circuit breaker component output terminal (22),
- a driving unit (30) for providing a driving voltage to be applied to the circuit breaker component driving terminal (26),
- an auxiliary driving unit (38) for providing an auxiliary driving voltage to be applied to the circuit breaker component driving terminal (26), wherein the auxiliary driving unit (38) is configured to generate the auxiliary driving voltage on the basis of a voltage drop between the circuit breaker component input terminal (18) and the circuit breaker component output terminal (22) when the circuit breaker component (14) is in its diode state and the circuit breaker component output terminal (22) is at a higher potential than the circuit breaker component input terminal (14), wherein the auxiliary driving unit (38) has a first auxiliary driving unit input terminal (40) connected to the circuit breaker component input terminal (18) and a second auxiliary driving unit input terminal (42) connected to the circuit breaker component output terminal (22),
**characterized in that** the auxiliary driving unit (38) is configured to multiply the potential difference present between the two auxiliary driving unit input terminals (40, 42) for providing the auxiliary driving voltage.

2. Circuit breaker device in accordance with claim 1, **characterized in that** the circuit breaker component (14) comprises a circuit breaker MOSFET component (16), wherein the circuit breaker component driving terminal (26) corresponds to the gate terminal (28) of the circuit breaker MOSFET component (16), the circuit breaker component input terminal (18) corresponds to the drain terminal (20) of the circuit breaker MOSFET component (16) and the circuit breaker component output terminal (22) corresponds to the source terminal (24) of the circuit breaker MOSFET component (16).

3. Circuit breaker device in accordance with claim 1 or 2, **characterized in that** the driving unit (30) has a first driving unit output terminal (32) for applying the driving voltage to the circuit breaker component driving terminal (26), or/and that the auxiliary driving unit (38) has an auxiliary driving unit output terminal (44) for applying the auxiliary driving voltage to the circuit breaker component driving terminal (26).

4. Circuit breaker device in accordance with claim 3, **characterized in that** a first decoupling circuit component (46) is associated with the auxiliary driving unit output terminal (44), wherein the first decoupling circuit component (46) decouples the auxiliary driving unit output terminal (44) from the circuit breaker component driving terminal (26) when the driving voltage provided by the driving unit (30) is applied to the circuit breaker component driving terminal (26).

5. Circuit breaker device in accordance with claim 4, **characterized in that** the first decoupling circuit component (46) comprises a first decoupling MOSFET component (48), the gate terminal (56) of which is connected to the first driving unit output terminal (32) preferably via a diode (54), the drain terminal (50) of which is connected to the auxiliary driving unit output terminal (44) and the source terminal (52) of which is connected to the circuit breaker component driving terminal (26).

6. Circuit breaker device in accordance with one of the preceding claims, **characterized in that** the driving unit (30) has a second driving unit output terminal (34) connected to the circuit breaker component output terminal (22).

7. Circuit breaker device in accordance with claim 3 or with one of the claims 4-6, if referred back to claim 3, **characterized in that** a discharge circuit component (58) is associated with the circuit breaker component driving terminal (26), wherein the discharge circuit component (58) is arranged between the first driving unit output terminal (32) and the circuit breaker component driving terminal (26), and the driving unit (30) applies the driving voltage to the circuit breaker component driving terminal (26) via the discharge circuit component (58), and wherein the circuit breaker component driving terminal (26) can be discharged via the discharge circuit component (58) when driving voltage is not provided by the driving unit (30).

8. Circuit breaker device in accordance with claim 7, **characterized in that** the discharge circuit component (58) comprises a discharge MOSFET component (60), the gate terminal (66) of which is connected to the first driving unit output terminal (32) preferably via a diode (54), the source terminal (62) of which is connected to the first driving unit output terminal (32) and the drain terminal (64) of which is connected to the circuit breaker component driving terminal (26), wherein the discharge MOSFET component (60) is in its diode state when driving voltage is provided by the driving unit (30).

9. Circuit breaker device in accordance with claim 8, **characterized in that** a discharge voltage source (68) is associated with the discharge MOSFET component (60), wherein the discharge voltage source (60) is configured to maintain the discharge MOSFET component (60) in its conductor state for a predefined time after ending the providing of driving voltage by the driving unit (30).

10. Circuit breaker device in accordance with claim 9, **characterized in that** the discharge voltage source (68) comprises an RC circuit (70).

11. Circuit breaker device in accordance with claim 3 or with one of the claims 4-10, if referred back to claim 3, **characterized in that** a second decoupling circuit component (76) is associated with the auxiliary driving unit (38), wherein the second decoupling circuit component (76) is arranged between the first driving unit output terminal (32) and the auxiliary driving unit output terminal (44), and wherein the second decoupling circuit component (76) decouples the auxiliary driving unit output terminal (44) from the first driving unit output terminal (32) when driving voltage is not provided by the driving unit (30) and auxiliary driving voltage is provided by the auxiliary driving unit (38).

12. Circuit breaker device in accordance with claim 11, **characterized in that** the second decoupling circuit component (76) comprises a second decoupling MOSFET component (78), the gate terminal (66) of which is connected to the first driving unit output terminal (32) preferably via a diode (54), the source terminal (62) of which is connected to the first driving unit output terminal (32) and the drain terminal (62) of which is connected to the auxiliary driving unit output terminal (44) when auxiliary driving voltage is provided by the auxiliary driving unit (38).

13. Circuit breaker device in accordance with claim 7 and claim 11 or 12, **characterized in that** the discharge circuit component (58) provides the second decoupling circuit component (76).

14. Circuit breaker device in accordance with one of the preceding claims, **characterized in that** the auxiliary driving unit (38) is configured to connect the circuit breaker component driving terminal (26) to the circuit breaker component output terminal (22) or/and to a ground potential terminal when the circuit breaker component (14) is in its diode state.

15. Circuit breaker device in accordance with claim 14, **characterized in that** the auxiliary driving unit (36) is configured to connect the auxiliary driving unit output terminal (44) to the second auxiliary driving unit input terminal (42) when the circuit breaker component (14) is in its diode state.

## Revendications

1. Arrangement de coupe-circuit, en particulier pour un système électrique de véhicule, comprenant:
- au moins un composant de coupe-circuit (14) avec une borne d'entrée de composant de coupe-circuit (18), avec une borne de sortie de composant de coupe-circuit (22) et avec une borne de commande de composant de coupe-circuit (26), où le composant de coupe-circuit (14) est dans un état conducteur quand de la tension de commande est appliquée à la borne de commande de composant de coupe-circuit (26) et où le composant de coupe-circuit (14) est dans un état de diode quand de la tension de commande n'est pas appliquée à la borne de commande de composant de coupe-circuit (26) de sorte que le composant de coupe-circuit (14) est dans un état bloqué quand la borne d'entrée de composant de coupe-circuit (18) est à un plus fort potentiel que la borne de sortie de composant de coupe-circuit (22),
- une unité de commande (30) pour fournir une tension de commande à être appliquée à la borne de commande de composant de coupe-circuit (26),
- une unité de commande auxiliaire (38) pour fournir une tension de commande auxiliaire à être appliquée à la borne de commande de composant de coupe-circuit (26), où l'unité de commande auxiliaire (38) est configurée pour générer la tension de commande auxiliaire sur la base d'une chute de tension entre la borne d'entrée de composant de coupe-circuit (18) et la borne de sortie de composant de coupe-circuit (22) quand le composant de coupe-circuit (14) est dans son état de diode et la borne de sortie de composant de coupe-circuit (22) est à un plus fort potentiel que la borne d'entrée de composant de coupe-circuit (14), où l'unité de commande auxiliaire (38) comprend une première borne d'entrée d'unité de commande auxiliaire (40) connectée à la borne d'entrée de composant de coupe-circuit (18) et une deuxième borne d'entrée d'unité de commande auxiliaire (42) connectée à la borne de sortie de composant de coupe-circuit (22),
**caractérisé en ce que** l'unité de commande auxiliaire (38) est configurée pour multiplier la différence de potentiel entre les deux bornes d'entrée d'unité de commande auxiliaire (40, 42) pour fournier la tension de commande auxiliaire.

2. Arrangement de coupe-circuit selon la revendication 1, **caractérisé en ce que** le composant de coupe-circuit (14) comprend un composant de coupe-circuit MOSFET (16), où la borne de commande de composant de coupe-circuit (26) correspond à la borne de grille (28) du composant de coupe-circuit MOSFET (16), la borne d'entrée de composant de coupe-circuit (18) correspond à la borne du drain (20) du composant de coupe-circuit MOSFET (16) et la borne de sortie de composant de coupe-circuit (22) correspond à la borne de source (24) du composant de coupe-circuit MOSFET (16).

3. Arrangement de coupe-circuit selon les revendications 1 ou 2, **caractérisé en ce que** l'unité de commande (30) comprend une première borne de sortie d'unité de commande (32) pour appliquer la tension de commande à la borne de commande de composant de coupe-circuit (26) ou/et **en ce que** l'unité de commande auxiliaire (38) comprend une borne de sortie d'unité de commande auxiliaire (44) pour appliquer la tension de commande à la borne de commande de composant de coupe-circuit (26).

4. Arrangement de coupe-circuit selon la revendication 3, **caractérisé en ce qu'**un premier composant de circuit de découplage (46) est associé à la borne de sortie d'unité de commande auxiliaire (44), où le premier composant de circuit de découplage (46) découple la borne de sortie d'unité de commande auxiliaire (44) de la borne de commande de composant de coupe-circuit (26) quand la tension de commande fournie par l'unité de commande (30) est appliquée à la borne de commande de composant de coupe-circuit (26).

5. Arrangement de coupe-circuit selon la revendication 4, **caractérisé en ce que** le premier composant de circuit de découplage (46) comprend un premier composant de découplage MOSFET (48), dont la borne de grille (56) est connectée à la première borne de sortie d'unité de commande (32), de préférence par une diode (54), dont la borne du drain (50) est connectée à la borne de sortie d'unité de commande auxiliaire (44) et dont la borne de source (52) est connectée à la borne de commande de composant de coupe-circuit (26).

6. Arrangement de coupe-circuit selon une des revendications précédentes, **caractérisé en ce que** l'unité de commande (30) comprend une deuxième borne de sortie d'unité de commande (34) connectée à la borne de sortie de composant de coupe-circuit (22).

7. Arrangement de coupe-circuit selon la revendication 3 ou selon une des revendications 4-6, si elles dépendent de la revendication 3, **caractérisé en ce qu'**un composant de circuit de décharge (58) est associé à la borne de commande de composant de coupe-circuit (26), ou le composant de circuit de décharge (58) est arrangé entre la première borne de sortie d'unité de commande (32) et la borne de commande de composant de coupe-circuit (26) et l'unité de commande (30) applique la tension de commande à la borne de commande de composant de coupe-circuit (26) via le composant de circuit de décharge (58), et où la borne de commande de composant de coupe-circuit (26) peut être déchargée via le composant de circuit de décharge (58) quand la tension de commande n'est pas fournie par l'unité de commande (30).

8. Arrangement de coupe-circuit selon la revendication 7, **caractérisé en ce que** le composant de circuit de décharge (58) comprend un composant de décharge MOSFET (60), dont la borne de grille (66) est connectée à la première borne de sortie d'unité de commande (32), de préférence par une diode (54) dont la borne source (62) est connectée à la première borne de sortie d'unité de commande (32) et dont la borne du drain (64) est connectée à la borne de commande de composant de coupe-circuit (26), ou le composant de décharge MOSFET (60) est dans son état de diode quand de la tension de commande est fournie par l'unité de commande (30).

9. Arrangement de coupe-circuit selon la revendication 8, **caractérisé en ce qu'**une source de tension de décharge (68) est associée au composant de décharge MOSFET (60), où la source de tension de décharge (60) est configurée pour maintenir le composant de décharge MOSFET (60) dans son état conducteur pendant un temps prédéfini après la fin de la mise à disposition de la tension de commande par l'unité de commande (30).

10. Arrangement de coupe-circuit selon la revendication 9, **caractérisé en ce que** la source de tension de décharge (68) comprend un circuit RC (70).

11. Arrangement de coupe-circuit selon la revendication 3 ou une des revendications 4-10 si elles dépendent de la revendication 3, **caractérisé en ce qu'**un deuxième composant de circuit de découplage (76) est associé à l'unité de commande auxiliaire (38), où le deuxième composant de circuit de découplage (76) est arrangé entre la première borne de sortie d'unité de commande (32) et la borne de sortie d'unité de commande auxiliaire (44), et où le deuxième composant de circuit de découplage (76) découple la borne de sortie d'unité de commande auxiliaire (44) de la première borne de sortie d'unité de commande (32) quand de la tension de commande n'est pas fournie par l'unité de commande (30) et quand de la tension de commande auxiliaire est fournie par l'unité de commande auxiliaire (38).

12. Arrangement de coupe-circuit selon la revendication 11, **caractérisé en ce que** le deuxième composant de circuit de découplage (76) comprend un deuxième composant de découplage MOSFET (78) dont la borne de grille (66) est connectée à la première borne de sortie d'unité de commande (32), de préférence via un diode (54), dont la borne source (62) est connectée à la première borne de sortie d'unité de commande (32) et dont la borne du drain (62) est connectée à la borne de sortie d'unité de commande auxiliaire (44) quand de la tension de commande auxiliaire est fournie par l'unité de commande auxiliaire (38).

13. Arrangement de coupe-circuit selon la revendication 7 et la revendication 11 ou 12, **caractérisé en ce que** le composant de circuit de décharge (58) prévoit le deuxième composant de circuit de découplage (76).

14. Arrangement de coupe-circuit selon une des revendications précédentes, **caractérisé en ce que** l'unité de commande auxiliaire (38) est configurée pour connecter la borne de commande de composant de coupe-circuit (26) à la borne de sortie de composant de coupe-circuit (22) ou/et à une borne de potentiel de terre quand le le composant de coupe-circuit (14) est dans son état de diode.

15. Arrangement de coupe-circuit selon la revendication 14, **caractérisé en ce que** l'unité de commande auxiliaire (36) est configurée pour connecter la borne de sortie d'unité de commande auxiliaire (44) à la deuxième borne d'entrée d'unité de commande auxiliaire (42) quand le composant de coupe-circuit (14) est dans son état de diode.
